# EUROPEAN PATENT SPECIFICATION

(11) **EP 3 285 307 B1**
(45) Date of publication and mention of the grant of the patent: **05.05.2021**
(21) Application number: 16779854.5
(22) Date of filing: 10.03.2016
(51) Int. Cl.: H01L 33/48, H01L 33/60, H01L 33/62, H01L 33/00, H01L 33/54, H01L 33/64

(54) **SEMICONDUCTOR LIGHT-EMITTING DEVICE AND METHOD FOR MANUFACTURING THE SAME**
LICHTEMITTIERENDES HALBLEITERBAUELEMENT UND HERSTELLUNGSVERFAHREN DAVON
DISPOSITIF ÉLECTROLUMINESCENT À SEMI-CONDUCTEURS ET SON PROCÉDÉ DE FABRICATION

(30) Priority: 17.04.2015 JP 2015084952
(43) Date of publication of application: 21.02.2018
(73) Proprietor: Samsung Electronics Co., Ltd., Suwon-si, Gyeonggi-do 16677 (KR)
(72) Inventor: AKAMATSU, Yuki, Tokyo 105-8001 (JP); NOGUCHI, Yoshio, Tokyo 105-8001 (JP); OGUSHI, Masahiro, Tokyo 105-8001 (JP); TAKEUCHI, Teruo, Tokyo 105-8001 (JP); KUROKI, Toshihiro, Tokyo 105-8001 (JP); EGOSHI, Hidenori, Tokyo 105-8001 (JP); ARAKAWA, Takashi, Tokyo 105-8001 (JP); INOUE, Kazuhiro, Tokyo 105-8001 (JP); KOMEYA, Toshihiro, Tokyo 105-8001 (JP)
(74) Representative: Kuhnen & Wacker Patent- und Rechtsanwaltsbüro PartG mbB
(86) International application number: PCT/JP2016/057667
(87) International publication number: WO 2016/167062

(56) References cited:
- EP-A1- 2 174 984
- JP-A- 2007 201 392
- JP-A- 2010 106 243
- JP-A- 2011 187 586
- JP-A- 2012 138 441
- JP-A- 2013 125 859
- JP-A- 2013 133 429
- JP-A- 2013 153 126
- JP-A- 2013 251 384
- JP-A- 2015 008 237
- JP-A- 2015 070 247
- US-A1- 2006 261 360
- US-A1- 2014 113 111
- US-A1- 2015 021 640

## Description

### [Technical Field]

Embodiments of the invention in accordance with the appended claims relate to a semiconductor light-emitting device and a method for manufacturing the same.

### [Background Art]

In a semiconductor light-emitting device, for example, a semiconductor light-emitting element such as a light-emitting diode (LED: Light Emitting Diode) or the like is mounted on a member such as a leadframe, etc. High productivity of the semiconductor light-emitting device is desirable.

### [Citation List] [Patent Literature]

From JP 2012-234955 A there is known an LED package including a first lead frame and a second lead frame mutually separated, an LED chip and a resin body. The LED chip is provided above the first and second lead frames. One terminal of the LED chip is connected to the first lead frame. One other terminal is connected to the second lead frame. The resin body covers an entire upper surface, a portion of a lower surface, and a portion of an end surface of each of the first and second lead frames. The resin body covers the LED chip. Remaining portions of the lower surface and the end surface of each of the first and second lead frames are exposed on the resin body. First and second recesses are made between the remaining portions of the first and second lead frames. An inner surface of each of the first and second recesses is not covered with the resin body. From JP 2012-138441 A there is known an LED substrate including a reflection layer which has good resistance against a corrosive gas and has a good reflection rate and a manufacturing method of the LED substrate, and to provide a semiconductor device including the reflection layer which stably maintains a high reflection rate for light emitted from an LED element. An LED substrate includes a base material and a reflection layer positioned at a desired region of the base material, and the reflection layer has a silver plating layer and a protection layer coating the silver plating layer. The protection layer includes : a layer including chrome or a chromium compound, a layer including chrome or the chromium compound and tin or a tin compound, or a layer including tin or the tin compound.
From JP 2013-125859 A there is known an optical semiconductor device lead frame used for an LED, a photocoupler, a photo interrupter and the like having an emission wavelength from a near-ultraviolet range to a visual light range, which has favorable reflectance, high luminance, excellent heat radiation properties, no corrosion and no damage to an LED element and the like even when a fracture part is exposed, excellent long-term reliability when mounting an element emitting light in the near-ultraviolet range, especially near a wavelength of 375 nm and in a visual light range, especially near a wavelength of 450 nm; and provide a manufacturing method of the optical semiconductor device lead frame. An optical semiconductor device lead frame includes a reflection layer on a part or on an entire surface of at least one surface or on both surfaces of outermost surfaces of a conductive substrate. The reflection layer has a composition which is subjected to a rolling treatment on at least a surface of a plating composition composed of silver or a silver alloy in at least an outermost surface of a region reflecting light emitted from an optical semiconductor element. A rolling processed surface of the optical semiconductor device lead frame has a recess for mounting an optical semiconductor element.

From JP 2011-187586 A there is known a lead frame that is buried in a glass substrate having a hollow formed on a surface; a part of the lead frame is exposed from a bottom surface of the hollow; another part is exposed from a side surface or reverse surface of the glass substrate;a light emitting element is mounted over the lead frame exposed on the bottom surface of the hollow; and a reflecting layer is formed, on a surface of the lead frame exposed on the bottom surface of the hollow, by laminating one of an Ni film, a Pt film and a Pd film, or a plurality of films, and an Ag film.

### [Summary of Invention]

### [Problem to be Solved by the Invention]

Embodiments of the invention provide a semiconductor light-emitting device in accordance with the appended claim 1, and a method in accordance with the appended claim 8 for manufacturing the semiconductor light-emitting device in which it is possible to increase the productivity

Advantageous, further embodiments of the invention are the object of the appended dependent claims.

### [Means for Solving the Problem]

The semiconductor light-emitting device according to the invention includes a first metal member, a semiconductor light-emitting element, and an insulating layer. The first metal member includes a first metal plate including copper, and a first metal layer including silver. The first metal layer is disposed between the semiconductor light-emitting element and the first metal plate. The insulating layer includes silicon oxide. The first metal plate includes a first region including copper, and a second region provided between the first region and the insulating layer. A concentration of oxygen in the second region is higher than a concentration of oxygen in the first region. The first metal plate has a first metal plate side surface of the second region, the first metal plate side surface crossing a plane perpendicular to a first direction; and the first direction is from the first metal layer toward the semiconductor light-emitting element. The insulating layer contacts the first metal plate side surface of the second region. The first metal plate side surface includes a region including silver.

### [Brief Description of Drawings]

[FIG. 1]

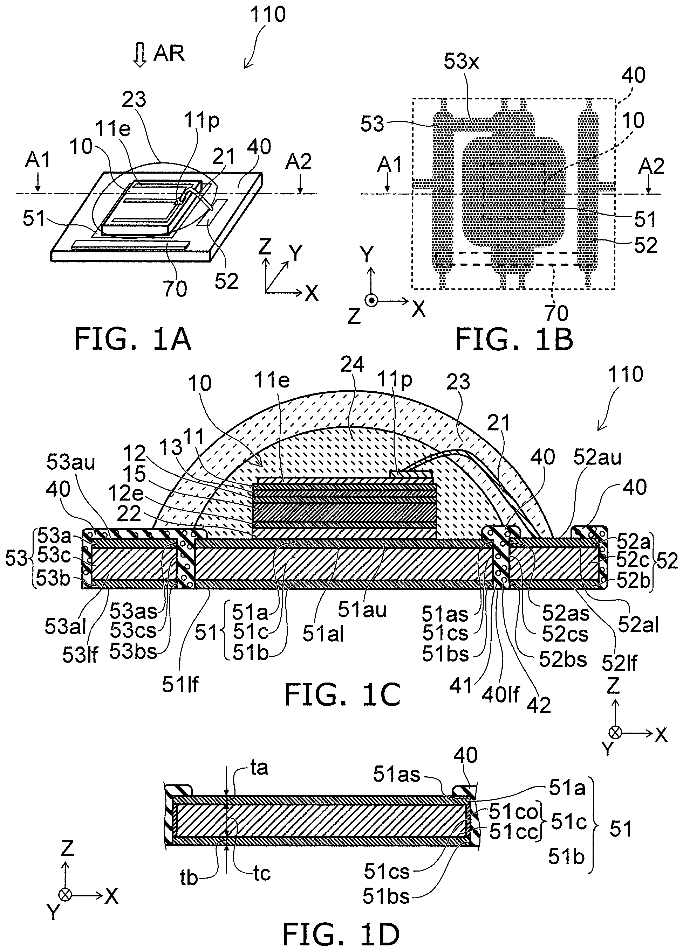

   FIG. 1A to FIG. 1D are schematic views illustrating a semiconductor light-emitting device according to a first embodiment.
[FIG. 2]

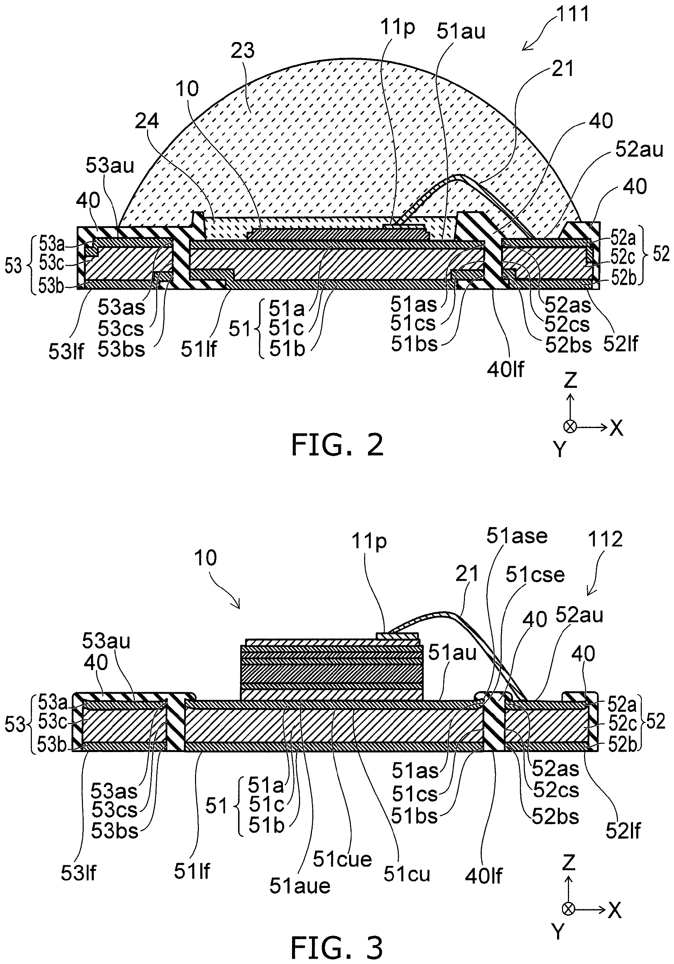

   FIG. 2 is a schematic cross-sectional view illustrating another semiconductor light-emitting device according to the first embodiment.
[FIG. 3]
   FIG. 3 is a schematic cross-sectional view illustrating another semiconductor light-emitting device according to the first embodiment.
[FIG. 4]

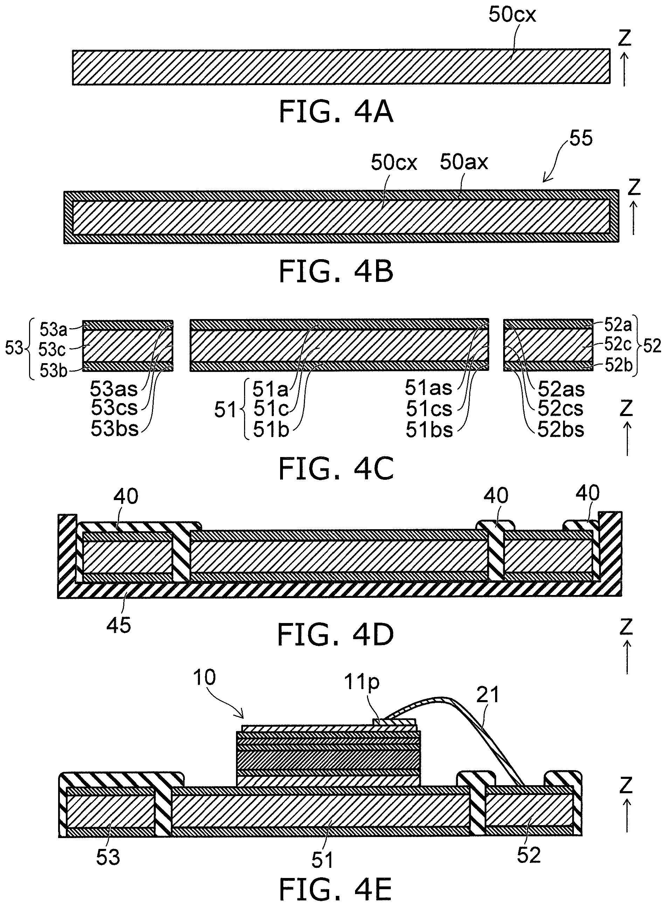

   FIG. 4A to FIG. 4E are schematic cross-sectional views in order of the processes, illustrating a method , according to a second embodiment, for manufacturing the semiconductor light-emitting device .
[FIG. 5]

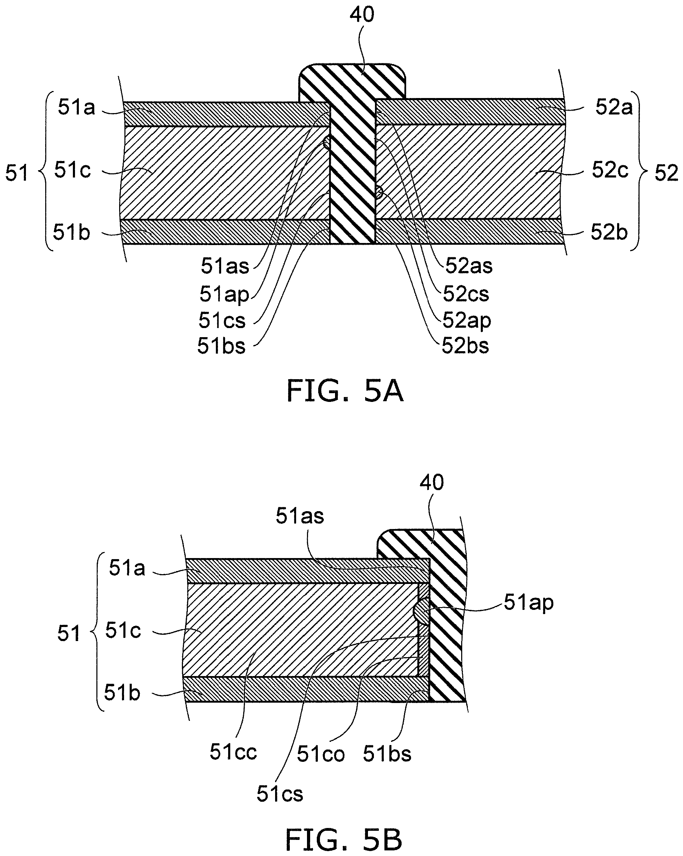

   FIG. 5A and FIG. 5B are schematic cross-sectional views illustrating a portion of a semiconductor light-emitting device according to an example, and a portion of the semiconductor light-emitting device according to an embodiment, respectively.

### [Description of Embodiments]

Various embodiments will be described hereinafter with reference to the accompanying drawings.

The drawings are schematic and conceptual; and the relationships between the thickness and width of portions, the proportions of sizes among portions, etc., are not necessarily the same as the actual values thereof. Further, the dimensions and proportions may be illustrated differently among drawings, even for identical portions.

In the specification and drawings, components similar to those described or illustrated in a drawing thereinabove are marked with like reference numerals, and a detailed description is omitted as appropriate.

### (First embodiment)

FIG. 1A to FIG. 1D are schematic views illustrating a semiconductor light-emitting device according to a first embodiment.

FIG. 1A is a perspective view. FIG. 1B is a plan view illustrating a portion of the semiconductor light-emitting device when viewed along arrow AR of FIG. 1A. Some of the components in FIG. 1B are displayed by broken lines. FIG. 1C is a cross-sectional view along line A1-A2 shown in FIG. 1A and FIG. 1B. FIG. 1D is a cross-sectional view illustrating a portion of the semiconductor light-emitting device.

As shown in FIG. 1A, the semiconductor light-emitting device 110 according to the embodiment includes a semiconductor light-emitting element 10, a first metal member 51, and an insulating layer 40. In the example, the semiconductor light-emitting device 110 further includes a second metal member 52.

In FIG. 1C, the thickness of the semiconductor light-emitting element 10 is drawn as being enlarged for easier viewing of the drawing.

As shown in FIG. 1C, the first metal member 51 includes a first metal plate 51c and a first metal layer 51a. In the example, the first metal member 51 further includes a first lower metal layer 51b. The first metal plate 51c is provided between the first metal layer 51a and the first lower metal layer 51b. The first metal plate 51c includes copper (Cu). The first metal plate 51c is, for example, a copper plate. The first metal layer 51a includes silver (Ag). The first metal layer 51a is, for example, a silver layer. The first lower metal layer 51b includes, for example, silver. The first lower metal layer 51b is, for example, a silver layer.

For example, a silver layer is formed by plating on the surface of the first metal plate 51c. Thereby, the first metal layer 51a (and the first lower metal layer 51b) are formed. The silver layer may be formed by vapor deposition.

The first metal layer 51a is disposed between the semiconductor light-emitting element 10 and the first metal plate 51c. The semiconductor light-emitting element 10 is, for example, an LED chip.

A first direction from the first metal layer 51a toward the semiconductor light-emitting element 10 is taken as a Z-axis direction. One direction perpendicular to the Z-axis direction is taken as an X-axis direction. A direction perpendicular to the Z-axis direction and the X-axis direction is taken as a Y-axis direction. The interface (a surface corresponding to a first lower surface 51al described below) between the first metal layer 51a and the first metal plate 51c is parallel to the X-Y plane.

The second metal member 52 is arranged with the first metal member 51 in a direction crossing the first direction (the Z-axis direction).

The second metal member 52 includes a second metal plate 52c and a second metal layer 52a. The second metal layer 52a overlaps at least a portion of the second metal plate 52c in the first direction. In the example, the second metal member 52 further includes a second lower metal layer 52b. The second metal plate 52c is provided between the second metal layer 52a and the second lower metal layer 52b. The second metal plate 52c includes copper. The second metal layer 52a includes, for example, silver. The second lower metal layer 52b includes, for example, silver. For example, the second metal layer 52a (and the second lower metal layer 52b) are formed by forming a silver layer on the surface of the second metal plate 52c by plating. The silver layer may be formed by vapor deposition.

A third metal member 53 is further provided in the example. The third metal member 53 is arranged with the first metal member 51 in a direction crossing the first direction (the Z-axis direction). In the example, the first metal member 51 is disposed between the third metal member 53 and the second metal member 52.

The third metal member 53 includes a third metal plate 53c and a third metal layer 53a. The third metal layer 53a overlaps at least a portion of the third metal plate 53c in the first direction. In the example, the third metal member 53 further includes a third lower metal layer 53b. The third metal plate 53c is provided between the third metal layer 53a and the third lower metal layer 53b. The third metal plate 53c includes copper. The third metal layer 53a includes, for example, silver. The third lower metal layer 53b includes, for example, silver. For example, the third metal layer 53a (and the third lower metal layer 53b) are formed by forming a silver layer on the surface of the third metal plate 53c by plating. The silver layer may be formed by vapor deposition.

FIG. 1B illustrates the first metal member 51, the second metal member 52, and the third metal member 53. As shown in FIG. 1B, the second metal member 52 is separated from the first metal member 51. The second metal member 52 is electrically insulated from the second metal member 51. A connection member 53x is provided in the example. The third metal member 53 is electrically connected to the first metal member 51 by the connection member 53x. These metal members are, for example, a leadframe.

The insulating layer 40 is provided on at least a portion of the first metal member 51. The insulating layer 40 includes silicon oxide 41. In the example, the insulating layer 40 further includes multiple particles 42. The multiple particles 42 include, for example, at least one of zinc oxide or titanium oxide. The insulating layer 40 is, for example, light-reflective. For example, the light reflectance of the insulating layer 40 is higher than the light reflectance of the first metal plate 51c.

For example, the insulating layer 40 holds the first metal member 51 and the second metal member 52. For example, the insulating layer 40 connects the first metal member 51 to the second metal member 52. The insulating layer 40 fixes the position of the second metal member 52 with respect to the first metal member 51. The insulating layer 40 holds the first metal member 51 and the second metal member 52 while electrically insulating between the first metal member 51 and the second metal member 52. The insulating layer 40 connects the first metal member 51 to the second metal member 52 while electrically insulating between the first metal member 51 and the second metal member 52.

As shown in FIG. 1C, the first metal plate 51c has a first metal plate side surface 51cs. The first metal plate side surface 51cs crosses the X-Y plane (a plane perpendicular to the first direction). The first metal layer 51a has a first metal layer side surface 51as. The first metal layer side surface 51as crosses the X-Y plane. The first lower metal layer 51b has a first lower metal layer side surface 51bs. The first lower metal layer side surface 51bs crosses the X-Y plane.

The second metal plate 52c has a second metal plate side surface 52cs. The second metal plate side surface 52cs crosses the X-Y plane. The second metal layer 52a has a second metal layer side surface 52as. The second metal layer side surface 52as crosses the X-Y plane. The second lower metal layer 52b has a second lower metal layer side surface 52bs. The second lower metal layer side surface 52bs crosses the X-Y plane.

In the embodiment, the insulating layer 40 contacts the first metal plate side surface 51cs. In the example, the insulating layer 40 contacts the first metal layer side surface 51as. The insulating layer 40 contacts the first lower metal layer side surface 51bs. The insulating layer 40 contacts the second metal plate side surface 52cs. The insulating layer 40 contacts the second metal layer side surface 52as. The insulating layer 40 contacts the second lower metal layer side surface 52bs.

High productivity is obtained in such a semiconductor light-emitting device 110.

For example, there is a reference example in which the first metal plate side surface 51cs of the first metal plate 51c is covered with a silver layer. For example, the configuration of the reference example is obtained by forming a metal plate by patterning the copper plate used to form the metal plate into a prescribed configuration, and by forming a silver layer on the surface of the metal plate by plating, etc. In the reference example, the surface of the copper metal plate is covered with the silver layer. In such a case, the insulating layer 40 contacts the silver layer but does not contact the surface of the copper metal plate. In such a reference example, it was found that there are cases where cracks, etc., occur in the insulating layer 40. The insulating layer 40 includes a portion contacting the corner portion of the metal member. The cracks occur easily in this portion.

For example, the insulating layer 40 that holds multiple (two) metal members is provided in the manufacturing processes of the semiconductor light-emitting device. Subsequently, there are cases where stress is applied to the two metal members in mutually-different directions. At this time, the stress is applied to the insulating layer 40; and cracks occur in the insulating layer 40. There are also cases where peeling occurs between the insulating layer 40 and the metal members. To this end, there are defects in which the positions of the two metal members are not at the prescribed positions. The insulative properties between the two metal members degrade. Thereby, for example, there are also cases where the reliability decreases. For example, there are also cases where the life in the high temperature/high humidity operation test decreases.

It was found that such problems occur particularly easily in the case where the insulating layer 40 has a high mechanical strength while being light-reflective. In the semiconductor light-emitting device, the light that is emitted from the semiconductor light-emitting element 10 is reflected by the insulating layer 40 and emitted to the outside. For example, the multiple particles 42 are provided in the insulating layer 40 to obtain high light reflectivity. It is desirable for the light absorbance of the matrix (the main body) provided around the multiple particles 42 to be low. Further, highly intense light is irradiated on the matrix from the semiconductor light-emitting element 10. Therefore, it is desirable for the matrix to have high lightfastness. Additionally, it is desirable for the insulating layer 40 to have high mechanical strength. Thereby, the two metal members can be held stably. For example, it is difficult to obtain high mechanical strength if a highly flexible material is used as the matrix of the insulating layer 40.

Therefore, in a configuration in which two metal members (leadframes) that are separated from each other are held by the insulating layer 40, the selection range of the material included in the insulating layer 40 is limited. By modifying the material included in the insulating layer 40, there is a limit to the suppression of the cracks and/or peeling of the insulating layer 40.

Such problems are problems that occur especially in a configuration in which the semiconductor light-emitting element 10 and multiple metal members are used, and the multiple metal members are held stably by the insulating layer while obtaining high light reflectance. The inventor of the application investigated methods to solve such a new problem.

The inventor of the application performed experiments in which the manufacturing processes of the leadframe were modified. Namely, a silver layer is formed on the surface of a copper plate; and subsequently, the silver layer and the copper plate are patterned into a prescribed configuration. It was found that the cracks and/or peeling of the insulating layer 40 can be suppressed in the configuration obtained by such a process.

In such a configuration, the side surface of the copper plate is not covered with the silver layer. Therefore, the side surface of the copper plate is exposed. The insulating layer 40 contacts the side surface of the copper plate. It is considered that the adhesion force between the insulating layer 40 and the copper is higher than the adhesion force between the insulating layer 40 and the silver because the surface energy of copper is higher than the surface energy of silver.

According to the experiments of the inventor of the application, it was found that the shear strength is about 335 gf/mm² when the insulating layer 40 is formed on the copper layer. On the other hand, it was found that the shear strength is about 12 gf/mm² when the insulating layer 40 is formed on the silver layer. Thus, the adhesion force between the insulating layer 40 and the copper is high.

In the embodiment, the insulating layer 40 contacts the first metal plate side surface 51cs. Thereby, good adhesion is obtained between the insulating layer 40 and the first metal plate side surface 51cs. Further, by the insulating layer 40 contacting the second metal plate side surface 52cs, good adhesion is obtained between the insulating layer 40 and the second metal plate side surface 52cs. Thereby, the cracks, etc., of the insulating layer 40 can be suppressed. Thereby, the yield increases. High productivity is obtained.

For example, the package strength is measured by applying stress to the semiconductor light-emitting device. For example, when stress is applied to the insulating layer 40, the positions of the two metal members change; and the insulating layer 40 is damaged. In such a package strength test, the package strength of the semiconductor light-emitting device 110 according to the embodiment is about 5 N (newtons) (not less than 4.4 N and not more than 5.6 N). On the other hand, in the reference example recited above (the entire surface of the copper plate being covered with the silver layer), the package strength is about 4 N (not less than 3.3 N and not more than 4.6 N). Thus, in the embodiment, a high package strength is obtained.

According to the embodiment, high reliability is obtained.

As shown in FIG. 1D, the first metal plate 51c has a thickness (a thickness tc) along the first direction (the Z-axis direction). The first metal layer 51a has a thickness (a thickness ta) along the first direction. The first lower metal layer 51b has a thickness (a thickness tb) along the first direction.

The thickness tc is thicker than the thickness ta and thicker than the thickness tb. Thereby, the contact surface area can be large between the first metal plate 51c and the insulating layer 40 having good adhesion force.

For example, the thickness tc along the first direction of the first metal plate 51c is, for example, not less than 500 times and not more than 5000 times the thickness ta along the first direction of the first metal layer 51a. When the thickness tc is less than 500 times the thickness ta, for example, there are cases where the adhesion force is insufficient. When the thickness tc exceeds 5000 times the thickness ta, for example, there are cases where the first metal layer 51a is excessively thin and the desired reflective characteristics are difficult to obtain. Or, for example, the first metal plate 51c is excessively thick; and the thickness of the entire device is thick. Similarly, the thickness tc is, for example, not less than 500 times and not more than 5000 times the thickness tb.

For example, the thickness ta of the first metal layer 51a is not less than 2 micrometers (µm) and not more than 10 µm. In the case where the thickness ta is less than 2 µm, for example, there are cases where a highly uniform reflectance is difficult to obtain. When the thickness ta exceeds 10 µm, for example, there are cases where cracks occur easily in the first metal layer 51a. Further, the manufacturing cost increases.

For example, the thickness tc of the first metal plate 51c is not less than 0.2 millimeters (mm) and not more than 1 mm. In the case where the thickness tc is less than 0.2 mm, for example, the mechanical strength is low. When the thickness tc exceeds 1 mm, the thickness of the semiconductor light-emitting device is thick. Further, the manufacturing cost increases.

As shown in FIG. 1D, the first metal plate 51c includes a first region 51cc and a second region 51co. The first region 51cc includes copper. The first region 51cc is, for example, a plate containing copper. The second region 51co is provided between the first region 51cc and the insulating layer 40. The concentration of oxygen in the second region 51co is higher than the concentration of oxygen in the first region 51cc. The second region 51co includes, for example, an oxide of copper. The second region 51co is, for example, a copper oxide film provided at a portion of the surface (the side surface) of the first region 51cc. In accordance with the invention, the first metal plate side surface 51cs of the first metal plate 51c is the side surface of the second region 51co.

For example, in the case where the first metal plate side surface 51cs includes copper oxide, there are cases where a chemical bond (e.g., a hydrogen bond) is formed between the insulating layer 40 and the copper oxide. Thereby, the adhesion force between the first metal plate side surface 51cs and the insulating layer 40 improves further. Thereby, the productivity increases further. The reliability increases further.

In the embodiment, the content ratio of the silicon oxide 41 inside the insulating layer 40 is, for example, 40% or more. The content ratio of the silicon oxide 41 may be 50% or more. The content ratio of the silicon oxide 41 is, for example, 70% or less. The content ratio of the silicon oxide 41 may be 60% or less.

The content ratio of the multiple particles 42 inside the insulating layer 40 is 20% or more. The content ratio of the multiple particles 42 may be 30% or more. The content ratio of the multiple particles 42 is, for example, 50% or less. The content ratio of the multiple particles 42 may be 40% or less.

The insulating layer 40 may further include an organic substance. The insulating layer 40 may further include a coupling agent. Thereby, the adhesion improves. The insulating layer 40 may include a hydrocarbon group. The insulating layer 40 may include a group including an unsaturated bond (e.g., an unsaturated hydrocarbon group, etc.). The insulating layer 40 may include, for example, a siloxane compound. The flexibility of the insulating layer 40 improves. Thereby, the stress is relaxed easily; and the cracks, etc., are suppressed.

As shown in FIG. 1C, the first metal layer 51a has a first upper surface 51au and the first lower surface 51al. The first lower surface 51al opposes the first metal plate 51c. The first upper surface 51au is the surface on the side opposite to the first lower surface 51al. The first upper surface 51au and the first lower surface 51al are aligned with the X-Y plane. The insulating layer 40 may contact at least a portion of the first upper surface 51au. The first upper surface 51au opposes the semiconductor light-emitting element 10.

The second metal layer 52a has a second upper surface 52au and a second lower surface 52al. The second lower surface 52al opposes the second metal plate 52c. The second upper surface 52au is the surface on the side opposite to the second lower surface 52al. The second upper surface 52au and the second lower surface 52al are aligned with the X-Y plane. The insulating layer 40 may contact at least a portion of the second upper surface 52au.

The third metal layer 53a has a third upper surface 53au and a third lower surface 53al. The third lower surface 53al opposes the third metal plate 53c. The third upper surface 53au is the surface on the side opposite to the third lower surface 53al. The third upper surface 53au and the third lower surface 53al are aligned with the X-Y plane. The insulating layer 40 may contact at least a portion of the third upper surface 53au.

By the insulating layer 40 contacting these upper surfaces, the insulating layer 40 can hold the metal members more securely. Thereby, the productivity increases further. The reliability increases further.

In the example of the semiconductor light-emitting device 110, a lower surface 52lf of the second metal member 52 is positioned substantially in a plane (the X-Y plane) including at least a portion of a lower surface 51lf of the first metal member 51. A lower surface 53lf of the third metal member 53 is positioned substantially in a plane (the X-Y plane) including at least a portion of the lower surface 51lf of the first metal member 51. A lower surface 40lf of the insulating layer 40 is positioned substantially in a plane (the X-Y plane) including at least a portion of the lower surface 51lf of the first metal member 51.

By these lower surfaces being positioned in the same plane, the electrical connection between these metal members is easy in the mounting of the semiconductor light-emitting device 110. Connections that have high reliability are obtained.

An example of the semiconductor light-emitting device 110 will now be described further.

As shown in FIG. 1C, the semiconductor light-emitting element 10 includes a first semiconductor layer 11, a second semiconductor layer 12, and a third semiconductor layer 13. For example, the first semiconductor layer 11 is of a first conductivity type. The second semiconductor layer 12 is provided between the first semiconductor layer 11 and the first metal member 51, for example. The second semiconductor layer 12 is of a second conductivity type. For example, the first conductivity type is an n-type; and the second conductivity type is a p-type. The first conductivity type may be the p-type; and the second conductivity type may be the n-type. The third semiconductor layer 13 is provided between the first semiconductor layer 11 and the second semiconductor layer 12. The third semiconductor layer 13 is, for example, a light-emitting layer. The first semiconductor layer 11, the second semiconductor layer 12, and the third semiconductor layer 13 include, for example, nitride semiconductors.

For example, the first metal member 51 is electrically connected to the second semiconductor layer 12. The second metal member 52 is electrically connected to the first semiconductor layer 11.

The semiconductor light-emitting element 10 includes a pad portion 11p. The pad portion 11p is electrically connected to the first semiconductor layer 11. A first electrode 11e is provided in the example. The first electrode 11e is electrically connected to the first semiconductor layer 11 and the pad portion 11p. The first electrode 11e is, for example, a fine wire electrode.

The semiconductor light-emitting element 10 further includes a base body 15 and a second electrode 12e. The base body 15 is provided on the second electrode 12e. The second semiconductor layer 12 is provided on the base body 15. The third semiconductor layer 13 is provided on the second semiconductor layer 12. The first semiconductor layer 11 is provided on the third semiconductor layer 13. The first electrode 11e and the pad portion 11p are provided on a portion of the first semiconductor layer 11. The base body 15 is, for example, conductive. The base body 15 includes, for example, a metal having an ohmic contact with the second semiconductor layer 12. A voltage is applied between the second electrode 12e and the pad portion 11p. Thereby, a current flows in the third semiconductor layer 13; and light is emitted from the third semiconductor layer 13. The semiconductor light-emitting element 10 is, for example, an LED.

The peak wavelength of the light emitted from the third semiconductor layer 13 is, for example, not less than 400 nm and not more than 480 nm. In the embodiment, the peak wavelength is arbitrary. The intensity of the light is a maximum at the peak wavelength.

A bonding layer 22 is provided between the first metal member 51 and the semiconductor light-emitting element 10. The bonding layer 22 is, for example, solder. The semiconductor light-emitting element 10 is fixed on the first metal member 51 by the bonding layer 22. The first metal member 51 is electrically connected to the second electrode 12e. The first metal member 51 is electrically connected to the second semiconductor layer 12.

The semiconductor light-emitting device 110 includes a wire 21. One end of the wire 21 is electrically connected to the pad portion 11p. The other end of the wire 21 is electrically connected to the second metal member 52. A voltage is applied to the semiconductor light-emitting element 10 by applying a voltage between the first metal member 51 and the second metal member 52; and light emission occurs.

A light-transmitting layer 23 is further provided in the example. The semiconductor light-emitting element 10 is disposed between the first metal member 51 and at least a portion of the light-transmitting layer 23. The light-transmitting layer 23 functions as, for example, a lens. The light-transmitting layer 23 may have a wavelength conversion function. In the example, a wavelength conversion layer 24 is provided between the light-transmitting layer 23 and the semiconductor light-emitting element 10. The wavelength conversion layer 24 absorbs a portion of first light emitted from the semiconductor light-emitting element 10 and emits second light. The peak wavelength of the second light is different from the peak wavelength of the first light. The first light is, for example, blue; and the second light is, for example, yellow (and may include red), etc. The synthesized light of the first light and the second light becomes the light of the semiconductor light-emitting device 110.

As shown in FIG. 1A and FIG. 1B, an electrical element 70 (e.g., a Zener diode or the like) is provided in the example. One end of the electrical element 70 is electrically connected to the third metal member 53. In other words, the one end of the electrical element 70 is electrically connected to the first metal member 51. The other end of the electrical element 70 is electrically connected to the second metal member 52. By providing the electrical element 70, the application of a reverse voltage to the semiconductor light-emitting element 10 can be suppressed.

FIG. 2 is a schematic cross-sectional view illustrating another semiconductor light-emitting device according to the first embodiment.

FIG. 2 is a drawing corresponding to the cross section along line A1-A2 shown in FIG. 1A and FIG. 1B.

In the other semiconductor light-emitting device 111 according to the embodiment as shown in FIG. 2, a portion of the metal member is positioned between the insulating layer 40 in the first direction. Also, the thickness of the insulating layer 40 changes. Otherwise, the semiconductor light-emitting device 111 is similar to the semiconductor light-emitting device 110; and a description is therefore omitted.

For example, a portion of the first metal member 51 is disposed between a portion of the insulating layer 40 and another portion of the insulating layer 40 in the first direction. A portion of the second metal member 52 is disposed between a portion of the insulating layer 40 and another portion of the insulating layer 40 in the first direction. A portion of the third metal member 53 may be disposed between a portion of the insulating layer 40 and another portion of the insulating layer 40 in the first direction. Thereby, the metal member is clamped between the insulating layer 40 from the vertical directions. Secure holding is obtained.

In the semiconductor light-emitting device 111, the lower surface 40lf of the insulating layer 40 is positioned substantially in a plane (the X-Y plane) including at least a portion of the lower surface 51lf of the first metal member 51 while clamping the metal member by a portion of the insulating layer 40. Secure holding and reliable electrical connections are obtained.

The height of a portion of the insulating layer 40 is higher than another portion of the insulating layer 40. For example, by setting the height of the portion of the insulating layer 40 around the semiconductor light-emitting element 10 to be high, for example, the control of the configuration of the resin (e.g., the wavelength conversion layer 24, etc.) covering the semiconductor light-emitting element 10 is easy.

FIG. 3 is a schematic cross-sectional view illustrating another semiconductor light-emitting device according to the first embodiment.

FIG. 3 is a drawing corresponding to the cross section along line A1-A2 shown in FIG. 1A and FIG. 1B.

In the other semiconductor light-emitting device 112 according to the embodiment as shown in FIG. 3, a portion of the first upper surface 51au of the first metal plate 51c proximal to the first metal plate side surface 51cs is tilted with respect to the X-Y plane. On the other hand, a portion of the first upper surface 51au overlapping the semiconductor light-emitting element 10 in the Z-axis direction is substantially aligned with (parallel to) the X-Y plane. Otherwise, the semiconductor light-emitting device 112 is similar to the semiconductor light-emitting device 110; and a description is therefore omitted. The light-transmitting layer 23 and the wavelength conversion layer 24 are not illustrated in FIG. 3.

The configuration in which the portion of the first upper surface 51au proximal to the first metal plate side surface 51cs is tilted with respect to the X-Y plane is formed in, for example, the formation process of the first metal member 51. For example, such a configuration (e.g., "burr") is formed when cutting the material used to form the metal member along a direction from the first lower metal layer 51b toward the first metal layer 51a.

For example, the first metal plate side surface 51cs has an end 51cse on the semiconductor light-emitting element 10 side. The first metal plate 51c has an upper surface 51cu. The upper surface 51cu opposes the first metal layer 51a. The upper surface 51cu includes a portion 51cue overlapping the semiconductor light-emitting element 10 in the first direction (the Z-axis direction). The position in the first direction of the end 51cse is provided between the position in the first direction of the portion 51cue and the position in the first direction of the semiconductor light-emitting element 10.

For example, the first metal layer side surface 51as of the first metal layer 51a has an end 51ase on the semiconductor light-emitting element 10 side. The first metal layer 51a has the upper surface 51au on the semiconductor light-emitting element 10 side. The upper surface 51au includes a portion 51aue overlapping the semiconductor light-emitting element 10 in the first direction (the Z-axis direction). The position in the first direction of the end 51ase is provided between the position in the first direction of the portion 51aue and the position in the first direction of the semiconductor light-emitting element 10.

In the semiconductor light-emitting device 112, a portion of the first metal plate 51c is positioned between the first metal layer 51a and the insulating layer 40. A portion of the second metal plate 52c is positioned between the second metal layer 52a and the insulating layer 40. A portion of the third metal plate 53c is positioned between the third metal layer 53a and the insulating layer 40.

In such a configuration, for example, the contact surface area between the insulating layer 40 and the first metal member 51 can be large. For example, the insulating layer 40 at the vicinity of the end 51ase clamps the first metal member 51 (the burr portion) in a direction crossing the Z-axis direction. Thereby, the holding of the first metal member 51 is performed with higher certainty due to the insulating layer 40.

For example, in the reference example recited above (the entire surface of the copper plate being covered with the silver layer), the silver layer is provided on the entire surface of the metal plate after forming the metal plate. In the reference example, the "burr" of the metal plate is smoothed because the silver layer is provided on the surface of the "burr." Therefore, it is difficult for the insulating layer 40 to clamp the burr portion in a direction crossing the Z-axis direction.

Conversely, in the embodiment, the strength of the holding is increased further by utilizing the burr.

### (Second embodiment)

The embodiment relates to a method for manufacturing the semiconductor light-emitting device.

FIG. 4A to FIG. 4E are schematic cross-sectional views in order of the processes, illustrating the method according to the second embodiment, for manufacturing the semiconductor light-emitting device .

These drawings show an example of the method for manufacturing the semiconductor light-emitting device 110.

As shown in FIG. 4A, a metal plate 50cx that includes copper is prepared.

As shown in FIG. 4B, a film 50ax that includes silver is formed on the surface of the metal plate 50cx. Thereby, a main body 55 is formed. The main body 55 includes the metal plate 50cx including copper, and the film 50ax including silver provided on the surface of the metal plate 50cx.

As shown in FIG. 4C, the first metal member 51 is formed by cutting the main body 55. In the example, the second metal member 52 and the third metal member 53 also are formed.

The first metal member 51 is obtained from the metal plate 50cx, has the first metal plate side surface 51cs, includes the first metal plate 51c, and includes the first metal layer 51a obtained from the film 50ax recited above. In the example, the first metal member 51 further includes the first lower metal layer 51b obtained from the film 50ax recited above.

The second metal member 52 is obtained from the metal plate 50cx, has the second metal plate side surface 52cs, includes the second metal plate 52c, and includes the second metal layer 52a obtained from the film 50ax recited above. In the example, the second metal member 52 further includes the second lower metal layer 52b obtained from the film 50ax recited above.

The third metal member 53 is obtained from the metal plate 50cx, has a third metal plate side surface 53cs, includes the third metal plate 53c, and includes the third metal layer 53a obtained from the film 50ax recited above. In the example, the third metal member 53 further includes the third lower metal layer 53b obtained from the film 50ax recited above.

As shown in FIG. 4D, the insulating layer 40 that includes silicon oxide is formed. For example, the formation of the insulating layer 40 is performed using a mold 45. The insulating layer 40 contacts the first metal plate side surface 51cs. The insulating layer 40 may contact the second metal plate side surface 52cs and the third metal plate side surface 53cs. The insulating layer 40 may contact the first metal layer side surface 51as, the second metal layer side surface 52as, and a third metal layer side surface 53as. The insulating layer 40 may contact the first lower metal layer side surface 51bs, the second lower metal layer side surface 52bs, and a third lower metal layer side surface 53bs.

As shown in FIG. 4E, the semiconductor light-emitting element 10 is disposed on the first metal layer 51a. A connection is performed using the wire 21 as necessary.

Thereby, the semiconductor light-emitting device 110 is made. In the manufacturing method, a semiconductor light-emitting device can be manufactured in which it is possible to increase the productivity.

In the configuration in which the insulating layer 40 contacts the copper (or the copper oxide) of the first metal plate side surface 51cs, for example, the silver (e.g., the first metal layer 51a, etc.) that has poor adhesion reduces the stress caused by the thermal expansion of the insulating layer 40, etc., when high temperature/low temperature thermal stress is applied to the semiconductor light-emitting device 110. Thereby, the reliability increases.

FIG. 5A and FIG. 5B are schematic cross-sectional views illustrating a portion of a semiconductor light-emitting device according to an example, and a portion of the semiconductor light-emitting device according to an embodiment of the invention, respectively.

As shown in FIG. 5A, a region (a first silver-containing region 51ap) that includes silver may be provided at the first metal plate side surface 51cs. A region (a second silver-containing region 52ap) that includes silver may be provided at the second metal plate side surface 52cs. For example, when patterning the metal member, there are cases where chips including silver formed from the metal layer including silver are adhered to the metal plate side surface. In such a case, a silver-containing region is formed at the metal plate side surface. In the case of the example, the first metal plate side surface 51cs includes a region including copper and a region including silver. According to the conditions of the analysis, there are cases where the first metal plate side surface 51cs includes copper and oxygen.

As shown in FIG. 5B, the first silver-containing region 51ap is provided in the second region 51co at the vicinity of the first metal plate side surface 51cs. In accordance with the invention, the first metal plate side surface 51cs includes a region 51 co including copper and oxygen and a region 51ap including silver. According to the conditions of the analysis and in accordance with the invention, the first metal plate side surface 51cs includes copper, oxygen, and silver.

In the example shown in FIG. 5A and in the embodiment shown in FIG. 5B, for example, the cracks of the insulating layer 40 are suppressed; a high yield is obtained; and high productivity is obtained. High reliability is obtained.

According to the embodiments recited above, a semiconductor light-emitting device and a method for manufacturing the semiconductor light-emitting device can be provided in which it is possible to increase the productivity.

In the specification, "nitride semiconductor" includes all compositions of semiconductors of the chemical formula B*ₓ*In*_{y}*Al*_{z}*Ga_{1-*x*-*y*-*z*}N (0 ≤ *x* ≤ 1, 0 ≤ *y* ≤ 1, 0 ≤ *z* ≤ 1, and *x*+*y*+*z* ≤ 1) for which the composition ratios x, y, and z are changed within the ranges respectively. "Nitride semiconductor" further includes group V elements other than N (nitrogen) in the chemical formula recited above, various elements added to control various properties such as the conductivity type and the like, and various elements included unintentionally.

In the specification of the application, "perpendicular" and "parallel" refer to not only strictly perpendicular and strictly parallel but also include, for example, the fluctuation due to manufacturing processes, etc. It is sufficient to be substantially perpendicular and substantially parallel.

Hereinabove, embodiments of the invention are described with reference to specific embodiments. However, the embodiments of the invention are not limited to these specific embodiments. For example, one skilled in the art may similarly practice the invention by appropriately selecting specific configurations of components included in the semiconductor light-emitting element such as the semiconductor light-emitting element, the semiconductor layer, the electrode, the metal member, the metal plate, the metal layer, the insulating layer, the wire etc., from known art, provided this falls within the scope of the invention as defined by the appended claims.

Further, any two or more components of the specific embodiments may be combined , provided this falls within the scope of the invention as defined by the appended claims.

Also, all semiconductor light-emitting devices and methods for manufacturing the same practicable by an appropriate design modification by one skilled in the art based on the semiconductor light-emitting devices and the method for manufacturing the same described above as embodiments of the invention are contemplated, provided they fall within the scope of the invention as defined by the appended claims.

Also, various modifications and alterations will be readily apparent to those skilled in the art, provided they fall within the scope of the invention as defined by the appended claims.

Although several embodiments of the invention are described, these embodiments are not intended to limit the scope of the invention. scope of the invention is defined by the appended claims.

## Claims

1. A semiconductor light-emitting device (110, 111, 112) comprising:
a first metal member (51) including
a first metal plate (51c) including copper, and
a first metal layer (51a) including silver;
a semiconductor light-emitting element (10), the first metal layer (51a) being disposed between the semiconductor light-emitting element (10) and the first metal plate (51c); and
an insulating layer (40) including silicon oxide,
the first metal plate (51c) including a first region (51cc) including copper, and
a second region (51co) provided between the first region (51cc) and the insulating layer (40),
a concentration of oxygen in the second region (51co) being higher than a concentration of oxygen in the first region (51cc),
the first metal plate (51 c) having a first metal plate side surface (51 cs) of the second region (51co), the first metal plate side surface (51cs) crossing a plane (X; Y)
perpendicular to a first direction (Z), the first direction (Z) being from the first metal layer (51a) toward the semiconductor light-emitting element (10), and
the insulating layer (40) contacting the first metal plate side surface (51cs) of the second region (51co),
**characterised in that** the first metal plate side surface (51cs) includes a region (51ap) including silver.

2. The semiconductor light-emitting device (110, 111, 112) according to claim 1,
wherein
the first metal layer (51a) has a first metal layer side surface (51as) crossing the plane (X; Y), and the insulating layer (40) contacts the first metal layer side surface (51as).

3. The semiconductor light-emitting device (110, 111, 112) according to claim 1 or 2, further comprising a second metal member (52),
the second metal member (52) including
a second metal plate (52c) including copper, and
a second metal layer (52a) including silver and overlapping at least a portion of the second metal plate (52c) in the first direction (Z),
the second metal member (52) being arranged with the first metal member (51) in a direction crossing the first direction (Z),
the second metal plate (52c) having a second metal plate
side surface (52cs) crossing the plane (X; Y), and the insulating layer (40) contacting the second metal plate side surface (52cs).

4. The semiconductor light-emitting device (110, 111, 112) according to claim 3, wherein the semiconductor light-emitting element (10) includes:
a first semiconductor layer (11) of a first conductivity type;
a second semiconductor layer (12) provided between the first semiconductor layer (11) and the first metal member (51), the second semiconductor layer (12) being of a second conductivity type; and
a third semiconductor layer (13) provided between the first semiconductor layer (11)
and the second semiconductor layer (12),
the first metal member (51) is electrically connected to the second semiconductor layer (12), and
the second metal member (52) is electrically connected to the first semiconductor layer (11).

5. The semiconductor light-emitting device (110, 111, 112) according to one of claims 1 to 4, wherein a content ratio of the silicon oxide inside the insulating layer (40) is 40% or more.

6. The semiconductor light-emitting device (110, 111, 112) according to one of claims 1 to 5, wherein the insulating layer (40) further includes a plurality of particles including zinc oxide.

7. The semiconductor light-emitting device (110, 111, 112) according to one of claims 1 to 6, wherein a thickness along the first direction of the first metal plate (51c) is not less than 500 times and not more than 5000 times a thickness along the first direction of the first metal layer (51a).

8. A method for manufacturing a semiconductor light-emitting device (110, 111, 112), comprising:
forming a first metal member (51) by cutting a main body (55) including a metal plate (50cx) and a film (50ax), the metal plate (50cx) including copper, the film (50ax) including silver and being provided at a surface of the metal plate (50cx), the first metal member (51) including a first metal plate (51c) and a first metal layer (51a), the first metal plate (51c) being obtained from the metal plate (50cx) and having a first metal plate side surface (51cs), the first metal layer (51a) being obtained from the film (50ax), the first metal plate (51c) including a first region (51cc) including copper, and a second region (51 co) forming the first metal plate side surface (51 cs), a concentration of oxygen in the second region (51co) being higher than a concentration of oxygen in the first region (51cc);
forming an insulating layer (40) contacting the first metal plate side surface (51cs) of the second region (51co) and including silicon oxide, whereby the second region (51co) is provided between the first region (51cc) and the insulating layer (40); and
disposing a semiconductor light-emitting element (10) on the first metal layer (51a).

## Patentansprüche

1. Halbleiterlichtemittiervorrichtung (110, 111, 112), aufweisend:
ein erstes Metallelement (51), das beinhaltet:
eine erste Metallplatte (51c), die Kupfer beinhaltet, und
eine erste Metallschicht (51a), die Silber beinhaltet;
ein Halbleiterlichtemittierelement (10), wobei die erste Metallschicht (51a) zwischen dem Halbleiterlichtemittierelement (10) und der ersten Metallplatte (51c) angeordnet ist; und
eine Isolierschicht (40), die Siliziumoxid beinhaltet,
wobei die erste Metallplatte (51c) einen ersten Bereich (51cc) beinhaltet, der Kupfer beinhaltet, und einen zweiten Bereich (51co), der sich zwischen dem ersten Bereich (51cc) und der Isolierschicht (40) befindet,
wobei eine Konzentration an Sauerstoff in dem zweiten Bereich (51co) höher ist als eine Konzentration an Sauerstoff in dem ersten Bereich (51cc),
wobei die erste Metallplatte (51c) eine erste Metallplattenseitenoberfläche (51cs) des zweiten Bereichs (51co) aufweist, wobei die erste Metallplattenseitenoberfläche (51cs) eine Ebene (X; Y) kreuzt, die zu einer ersten Richtung (Z) rechtwinklig ist, wobei die erste Richtung (Z) von der ersten Metallschicht (51a) in Richtung des Halbleiterlichtemittierelements (10) verläuft, und
wobei die Isolierschicht (40) die erste Metallplattenseitenoberfläche (51cs) des zweiten Bereichs (51co) berührt,
**dadurch gekennzeichnet, dass** die erste Metallplattenseitenoberfläche (51cs) einen Bereich (51ap) beinhaltet, der Silber beinhaltet.

2. Halbleiterlichtemittiervorrichtung (110, 111, 112) nach Anspruch 1, wobei die erste Metallschicht (51a) eine erste Metallschichtseitenoberfläche (51as) aufweist, die die Ebene (X; Y) kreuzt, und
wobei die Isolierschicht (40) die erste Metallschichtseitenoberfläche (51as) berührt.

3. Halbleiterlichtemittiervorrichtung (110, 111, 112) nach Anspruch 1 oder 2, ferner aufweisend ein zweites Metallelement (52),
wobei das zweite Metallelement (52) eine zweite Metallplatte (52c), die Kupfer beinhaltet, und eine zweite Metallschicht (52a), die Silber beinhaltet, beinhaltet und sich mit zumindest einem Teil der zweiten Metallplatte (52c) in der ersten Richtung (Z) überlappt,
wobei das zweite Metallelement (52) mit dem ersten Metallelement (51) in einer Richtung angeordnet ist, die die erste Richtung (Z) kreuzt,
wobei die zweite Metallplatte (52c) eine zweite Metallplattenseitenoberfläche (52cs) aufweist, die die Ebene (X; Y) kreuzt, und
wobei die Isolierschicht (40) die zweite Metallplattenseitenoberfläche (52cs) berührt.

4. Halbleiterlichtemittiervorrichtung (110, 111, 112) nach Anspruch 3,
wobei das Halbleiterlichtemittierelement (10) beinhaltet:
eine erste Halbleiterschicht (11) eines ersten Leitfähigkeitstyps;
eine zweite Halbleiterschicht (12), die sich zwischen der ersten Halbleiterschicht (11) und dem ersten Metallelement (51) befindet, wobei die zweite Halbleiterschicht (12) einem zweiten Leitfähigkeitstyp angehört; und
eine dritte Halbleiterschicht (13), die sich zwischen der ersten Halbleiterschicht (11) und der zweiten Halbleiterschicht (12) befindet,
wobei das erste Metallelement (51) mit der zweiten Halbleiterschicht (12) elektrisch verbunden ist, und
wobei das zweite Metallelement (52) mit der ersten Halbleiterschicht (11) elektrisch verbunden ist.

5. Halbleiterlichtemittiervorrichtung (110, 111, 112) nach einem der Ansprüche 1 bis 4, wobei ein Gehaltsverhältnis des Siliziumoxids im Inneren der Isolierschicht (40) 40% oder mehr beträgt.

6. Halbleiterlichtemittiervorrichtung (110, 111, 112) nach einem der Ansprüche 1 bis 5, wobei die Isolierschicht (40) ferner eine Mehrzahl an Partikeln einschließlich Zinkoxid beinhaltet.

7. Halbleiterlichtemittiervorrichtung (110, 111, 112) nach einem der Ansprüche 1 bis 6, wobei eine Dicke entlang der ersten Richtung der ersten Metallplatte (51c) nicht niedriger ist als ein 500-faches und nicht höher als ein 5000-faches einer Dicke entlang der ersten Richtung der ersten Metallschicht (51a).

8. Verfahren zum Herstellen einer Halbleiterlichtemittiervorrichtung (110, 111, 112), aufweisend:
Bilden eines ersten Metallelements (51) durch Schneiden eines Hauptkörpers (55), der eine Metallplatte (50cx) und einen Film (50ax) enthält, wobei die Metallplatte (50cx) Kupfer beinhaltet, der Film (50ax) Silber beinhaltet und sich an einer Oberfläche der Metallplatte (50cx) befindet, wobei das erste Metallelement (51) eine erste Metallplatte (51c) und eine erste Metallschicht (51a) beinhaltet, wobei die erste Metallplatte (51c) aus der Metallplatte (50cx) erhalten wird und eine erste Metallplattenseitenoberfläche (51cs) aufweist, wobei die erste Metallschicht (51a) aus dem Film (50ax) erhalten wird, wobei die erste Metallplatte (51c) einen ersten Bereich (51cc) beinhaltet, der Kupfer enthält, und einen zweiten Bereich (51co) beinhaltet, der die erste Metallplattenseitenoberfläche (51cs) bildet, wobei eine Konzentration an Sauerstoff in dem zweiten Bereich (51co) höher ist als eine Konzentration an Sauerstoff in dem ersten Bereich (51cc);
Bilden einer Isolierschicht (40), die die erste Metallplattenseitenoberfläche (51cs) des zweiten Bereichs (51co) berührt und Siliziumoxid beinhaltet, wobei sich der zweite Bereich (51co) zwischen dem ersten Bereich (51cc) und der Isolierschicht (40) befindet; und
Aufbringen eines Halbleiterlichtemittierelements (10) auf die erste Metallschicht (51a).

## Revendications

1. Dispositif électroluminescent à semi-conducteur (110, 111, 112) comprenant :
un premier organe métallique 51) comprenant
une première plaque métallique (51c) comprenant du cuivre, et
une première couche de métal (51a) comprenant de l'argent ;
un élément électroluminescent semi-conducteur (10), la première couche de métal (51a) étant disposée entre l'élément électroluminescent semi-conducteur (10) et la première plaque métallique (51c) ; et
une couche isolante (40) comprenant de l'oxyde de silicium,
la première plaque métallique (51c) comprenant une première zone (51cc) comprenant du cuivre, et une seconde zone (51co) prévue entre la première zone (51cc) et la couche isolante (40),
une concentration en oxygène dans la seconde zone (51co) étant supérieure à une concentration en oxygène dans la première zone (51cc),
la première plaque métallique (51c) ayant une surface côté première plaque métallique (51cs) de la seconde zone (51co), la surface côté première plaque métallique (51cs) croisant un plan (X ; Y) perpendiculaire à une première direction (Z), la première direction (Z) allant de la première couche de métal (51a) vers l'élément électroluminescent semi-conducteur (10), et
la couche isolante (40) étant en contact avec la surface côté première plaque métallique (51cs) de la seconde zone (51co),
**caractérisé en ce que**
la surface côté première plaque métallique (51cs) comprend une zone (51ap) comprenant de l'argent.

2. Dispositif électroluminescent à semi-conducteur (110, 111, 112) selon la revendication 1, dans lequel
la première couche de métal (51a) possède une surface côté première couche de métal (51as) qui croise le plan (X ; Y), et
la couche isolante (40) est en contact avec la surface côté première couche de métal (51as).

3. Dispositif électroluminescent à semi-conducteur (110, 111, 112) selon la revendication 1 ou 2, comprenant en outre un organe élément métallique (52),
le second organe métallique (52) comprenant
une seconde plaque métallique (52c) comprenant du cuivre, et
une seconde couche de métal (52a) comprenant de l'argent et chevauchant au moins une partie de la seconde plaque métallique (52c) dans la première direction (Z),
le second organe métallique (52) étant disposé avec le premier organe métallique (51) dans une direction qui croise la première direction (Z),
la seconde plaque métallique (52c) ayant une surface côté seconde plaque métallique (52cs) qui croise le plan (X ; Y), et
la couche isolante (40) étant en contact avec la surface côté seconde plaque métallique (52cs).

4. Dispositif électroluminescent à semi-conducteur (110, 111, 112) selon la revendication 3, dans lequel l'élément électroluminescent semi-conducteur (10) comprend :
une première couche semi-conductrice (11) d'un premier type de conductivité ;
une seconde couche semi-conductrice (12) prévue entre la première couche semi-conductrice (11) et le premier organe métallique (51), la seconde couche semi-conductrice (12) étant d'un second type de conductivité ; et
une troisième couche semi-conductrice (13) prévue entre la première couche semi-conductrice (11) et la seconde couche semi-conductrice (12),
le premier organe métallique (51) est électriquement relié à la seconde couche semi-conductrice (12), et
le second organe métallique (52) est électriquement relié à la première couche semi-conductrice (11).

5. Dispositif électroluminescent à semi-conducteur (110, 111, 112) selon l'une des revendications 1 à 4, dans lequel un rapport de teneur en oxyde de silicium à l'intérieur de la couche isolante (40) est de 40 % ou plus.

6. Dispositif électroluminescent à semi-conducteur (110, 111, 112) selon l'une des revendications 1 à 5, dans lequel la couche isolante (40) comprend en outre une pluralité de particules comprenant de l'oxyde de zinc.

7. Dispositif électroluminescent à semi-conducteur (110, 111, 112) selon l'une des revendications 1 à 6, dans lequel une épaisseur le long de la première direction de la première plaque métallique (51c) est non inférieure à 500 fois et non supérieure à 5000 fois une épaisseur le long de la première direction de la première couche métallique (51a).

8. Procédé de fabrication d'un dispositif électroluminescent à semi-conducteur (110, 111, 112) comprenant les étapes consistant en :
la formation d'un premier organe métallique (51) en découpant un corps principal (55) comprenant une plaque métallique (50cx) et un film (50ax), la plaque métallique (50cx) comprenant du cuivre, le film (50ax) comprenant de l'argent et étant prévu au niveau d'une surface de la plaque métallique (50cx), le premier organe métallique (51) comprenant une première plaque métallique (51c) et une première couche de métal (51a), la première plaque métallique (51c) étant obtenue à partir de la plaque métallique (50cx) et ayant une surface côté première plaque métallique (51cs), la première couche de métal (51a) étant obtenue à partir du film (50ax), la première plaque métallique (51c) comprenant une première zone (51cc) comprenant du cuivre, et une seconde zone (51co) formant la surface côté première plaque métallique (51cs), une concentration en oxygène dans la seconde zone (51co) étant supérieure à une concentration en oxygène dans la première zone (51cc) ;
la formation d'une couche isolante (40) en contact avec la surface côté première plaque métallique (51cs) de la seconde zone (51co) et comprenant de l'oxyde de silicium, moyennant quoi la seconde zone (51co) est prévue entre la première zone (51cc) et la couche isolante (40) ; et
la disposition d'un élément électroluminescent semi-conducteur (10) sur la première couche de métal (51a).
